Europäisches Patentamt

European Patent Office

Office européen des brevets

(11) Veröffentlichungsnummer: **0 081 746**
**A2**

(12) **EUROPÄISCHE PATENTANMELDUNG**

(21) Anmeldenummer: 82111094.7

(22) Anmeldetag: 01.12.82

(51) Int. Cl.³: **H 05 K 13/04**

(30) Priorität: 09.12.81 DE 3148674

(43) Veröffentlichungstag der Anmeldung: **22.06.83**
Patentblatt 83/25

(84) Benannte Vertragsstaaten: **DE FR GB IT**

(71) Anmelder: **ROBERT BOSCH GMBH, Postfach 50,
D-7000 Stuttgart 1 (DE)**

(72) Erfinder: **Hecht, Dieter, Königseestrasse 20,
D-7000 Stuttgart 50 (DE)**

(54) Vorrichtung mit Saugröhrchen zum Bestücken von Leiterplatten mit plättchenförmigen elektronischen Bauelementen.

(57) Vorrichtung zum Bestücken von Leiterplatten mit plättchenförmigen elektronischen Bauelementen (16), bei welcher die Bauelemente (16) in einem Bündel von röhrchenförmigen Magazinen (10) gestapelt sind, welches das gleiche Raster wie das Layout der Leiterplatte hat, und durch ein Bündel von Saugröhrchen (26) auf die Leiterplatte aufgesetzt werden. Die Mündungen (34) der Saugröhrchen (26) sind von elastisch verformbaren Kragen (40) umgeben, welche vorzugsweise durch auf die Saugröhrchen (26) aufgeschobene und über deren Stirnende (36) vorstehende flexible Schläuche (30) gebildet sind. Dadurch wird ein Beschädigen der bruchgefährdeten empfindlichen Bauelemente vermieden und eine gute Abdichtung zwischen den Mündungen der Saugröhrchen (26) und den anliegenden Seitenflächen der Bauelemente (16) gewährleistet.

R. 17514

11.11.1981 Ki/Le

0081746

-7-

ROBERT BOSCH GMBH, 7000 STUTTGART 1

Vorrichtung mit Saugröhrchen zum Bestücken
von Leiterplatten mit plättchenförmigen
elektronischen Bauelementen

Stand der Technik

Die Erfindung geht aus von einer Vorrichtung nach der
Gattung des Hauptanspruchs. Beim Bestücken von Leiterplatten mit plättchenförmigen elektronischen Bauelementen,
sogenannten Chips, kommt es wegen des hohen Miniaturisierungsgrades dieser Schaltungstechnik auf eine sehr
genaue Positionierung der Bauelemente auf der Leiterplatte an. Die Bauelemente selbst sind so klein und
dünn, daß die Vorrichtungsteile zum Halten und Transportieren der Bauelemente sehr maßgenau ausgeführt
und zueinander angeordnet sein müssen. Zum Aufsetzen
der Bauelemente auf die Leiterplatte ist bei der
gattungsmäßigen Vorrichtung ein Bündel von Saugröhrchen vorgesehen, mit denen auch extrem kleine
und dünne Bauelemente erfasst und an die mit einen

. . .

Klebstoffauftrag vorbehandelte Leiterplatte angedrückt werden können. Dabei muß jedoch für einen
Toleranzausgleich gesorgt werden, damit jedes Saugröhrchen satt auf dem Bauelement aufliegt und der
angelegte Unterdruck voll zur Wirkung kommt. Bei
einer bekannten Vorrichtung der gattungsmäßigen
Art (DE-OS 29 35 021) sind die Saugröhrchen zum
Zweck des Toleranzausgleichs gegen den Druck von
flachen Federelementen in ihrer Halterung gelagert.
Diese Ausführung erscheint verhältnismäßig aufwendig
und auch insofern nachteilig, weil wegen des nur geringen Federwegs der Federelemente in Verbindung
mit den starr ausgeführten Mündungsbereichen der
Saugröhrchen Beschädigungen der empfindlichen keramischen Elemente nicht ganz ausgeschlossen werden
können.

Vorteile der Erfindung

Die erfindungsgemäße Anordnung mit den kennzeichnenden
Merkmalen des Hauptanspruchs hat demgegenüber den Vorteil, daß die auf den Kragen verlagerte Mündungsebene
der Saugröhrchen wesentlich bessere Federungseigenschaften hat und auch in sich elastisch ausgeführt sein
kann, so daß ein hartes Aufsetzen der Saugröhrchen auf
die Bauelemente bei allen vorkommenden Toleranzpaarungen
vermieden und eine einwandfreie Dichtung zwischen den
Mündungen der Saugröhrchen und der anliegenden Seitenfläche der Bauelemente gewährleistet ist. Die Kragen
können auf einfache Weise durch auf die Saugröhrchen
aufgeschobene und über deren Stirnende vorstehende
flexible Schläuche gebildet sein.

. . .

Zeichnung

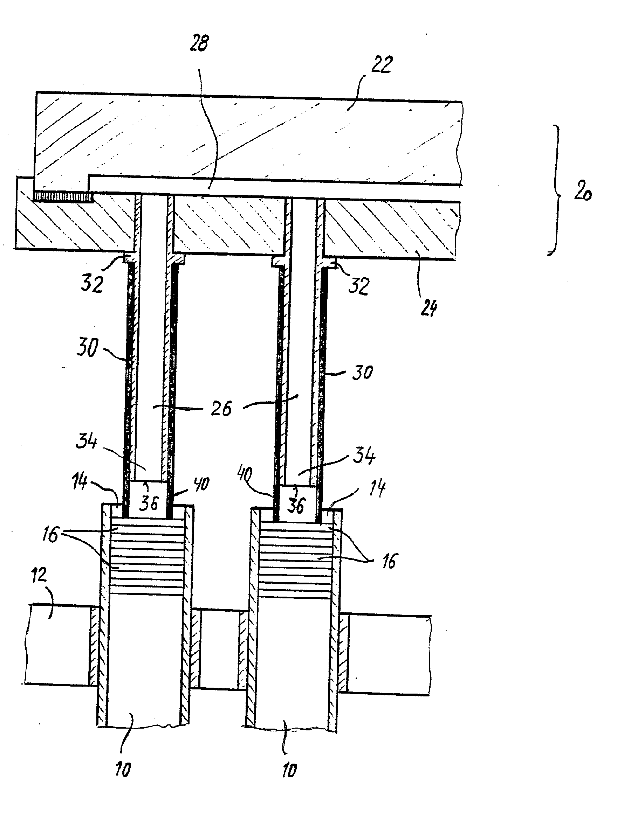

Ein Ausführungsbeispiel der Erfindung ist in der
Zeichnung dargestellt und in der nachfolgenden Beschreibung näher erläutert. Die einzige Figur zeigt
ein Schnittbild von zwei Saugröhrchen der Vorrichtung samt ihrer Halterung und den zugeordneten
Magazinen für die Bauelemente.

Beschreibung des Ausführungsbeispieles

Die Vorrichtung ist mit einem Bündel von senkrecht
stehenden Magazinen 10 versehen, deren gegenseitige
Zuordnung der vorgesehenen Anordnung der Bauelemente
auf den zu bestückenden Leiterplatten entspricht. Die
Magazine 10 sind in einen Rahmen 12 eingeschoben und
darin so arretiert, daß ihre Ausgangsöffnungen 14 in
einer gemeinsamen Ebene liegen. In jedem Magazin 10
ist ein Stapel von Bauelementen 16 enthalten, welcher
durch nicht dargestellte Mittel von unten nach oben
gegen die Ausgangsöffnung 14 des Magazins gedrückt ist.

Die Vorrichtung ist ferner mit einem Support 20 versehen, der aus einer Tragplatte 22 und einer Halteplatte 24 für ein Bündel von Saugröhrchen 26 besteht.
Zwischen Tragplatte 22 und der Halteplatte 24 ist ein
gegen Atmosphäre abgedichteter Raum 28 gebildet, der
über nicht gezeigte Kanäle in einer der beiden Platten
22, 24 mit einer Unterdruckquelle verbindbar ist. Die
Saugröhrchen 26 haben das gleiche Raster wie die Magazine 10 und münden in den Raum 28 ein, so daß ein

. . .

angelegter Unterdruck auch in den Saugröhrchen 26 wirksam ist. Der Support 20 ist mit einem nicht dargestellten Antrieb versehen, welcher den Support in Achsrichtung der Saugröhrchen 26 und quer dazu bewegt.

Auf jedes Saugröhrchen 26 ist ein Schlauch 30 aus elastischem Kunststoff bis zu einem Bund 32 am Saugröhrchen 26 aufgeschoben, welcher auch die auf das Saugröhrchen 26 ausgeübten axialen Kräfte auffängt. Die Schläuche 30 sind so lang bemessen, daß sie über die die Mündungen 34 umgebenden Stirnränder 36 der Saugröhrchen 26 hervorstehen. Die hervorstehenden Endbereiche der Schläuche 30 bilden auf diese Weise elastische Kragen 40, welche die Mündungen 34 der Saugröhrchen 26 umgeben.

Im Betrieb der Vorrichtung sitzen in der gezeichneten Stellung des Supportes 20 die Saugröhrchen 26 mit ihren Kragen 40 federnd elastisch auf die in den Magazinen 10 jeweils oben liegenden Bauelemente 16 auf, so daß eine Beschädigung der Bauelemente vermieden wird. Durch die Elastizität der Kragen 40 wird gleichzeitig ein vollständig dichter Abschluß der Saugröhrchen 26 sichergestellt, so daß der angelegte Unterdruck voll wirksam werden kann. Durch entsprechende Bewegungen des Supportes 20 werden die Bauelemente 16 aus den Magazinen herausgehoben und auf die zu bestückende Leiterplatte aufgesetzt.

Die erfindungsgemäße Ausbildung der Saugröhrchen 26 ist nicht auf solche Vorrichtungen beschränkt, bei denen die Bauelemente bereits mit Hilfe der Saugröhrchen aus den Magazinen herausgehoben werden. Diese Ausbildung der Saugröhrchen läßt sich mit gleichen Vorteilen auch bei solchen Vorrichtungen nutzen, bei denen die Bauelemente

. . .

0081746

unter dem Einfluß der Schwerkraft aus den Magazinen
heraus in Transportschieber gelangen und bei denen
die Saugröhrchen die Bauelemente lediglich aus dem
Transportschieber herausgreifen und auf die Leiterplatte aufsetzen.

R.

11.11.1981 Ki/Le

0081746

ROBERT BOSCH GMBH, 7000 STUTTGART 1

Ansprüche

1. Vorrichtung zum Bestücken von Leiterplatten mit
plättchenförmigen elektronischen Bauelementen, mit
einem Bündel von senkrecht stehenden Magazinen, in
denen die Bauelemente einzeln übereinanderliegend
stapelbar sind, deren gegenseitige Zuordnung der vorgesehenen Anordnung der Bauelemente auf der Leiterplatte entspricht und deren Ausgangsöffnungen vorzugsweise in einer gemeinsamen Ebene liegen, und
ferner mit einer Transporteinrichtung zum gleichzeitigen Abnehmen aller in einem Arbeitsgang aufzubringender Bauelemente von den Ausgangsöffnungen
der Magazine und zum Überführen der Bauelemente auf
die Leiterplatte, wobei zumindest das Aufsetzen der
Bauelemente auf die Leiterplatte mit Hilfe eines
Bündels von Saugröhrchen erfolgt, an deren Mündungen
die Bauelemente durch Unterdruck festgehalten sind,
dadurch gekennzeichnet, daß die Mündungen (34) der
Saugröhrchen (26) von elastisch verformbaren Kragen
(40) umgeben sind.

...

2. Vorrichtung nach Anspruch 1, dadurch gekennzeichnet, daß die Kragen (40) durch auf die Saugröhrchen (26) aufgeschobene und über deren Stirnende (36) vorstehende flexible Schläuche (30) gebildet sind.